(19) Europäisches Patentamt
European Patent Office
Office européen des brevets

(11) EP 1 734 530 B1

(12) **EUROPEAN PATENT SPECIFICATION**

(45) Date of publication and mention
of the grant of the patent:
**12.12.2007 Bulletin 2007/50**

(51) Int Cl.:
**G11B 20/14** (2006.01)  **G11B 27/30** (2006.01)
**H03L 7/091** (2006.01)

(21) Application number: **06252883.1**

(22) Date of filing: **03.06.2006**

(54) **Run length based frequency detector for phase locked loop circuit and corresponding method**

Auf Run-length basierender Frequenzdetektor für eine Phasenregelschleife und dazu gehöriges Verfahren

Détecteur de fréquence basé sur les run length pour une boucle à verrouillage de phase et méthode associée

(84) Designated Contracting States:
**AT BE BG CH CY CZ DE DK EE ES FI FR GB GR HU IE IS IT LI LT LU LV MC NL PL PT RO SE SI SK TR**

(30) Priority: **10.06.2005 KR 20050049696**

(43) Date of publication of application:
**20.12.2006 Bulletin 2006/51**

(73) Proprietor: **Samsung Electronics Co., Ltd.**
**Suwon-si, Gyeonggi-Do (KR)**

(72) Inventors:
• **Zhao, Hui**
**Suwon-si, Gyeonggi-do (KR)**

• **Park, Hyun-soo**
**Seoul (KR)**
• **Lee, Jae-wook**
**Osan-si, Gyeonggi-do (KR)**

(74) Representative: **Clark, David James et al**
**Appleyard Lees**
**15 Clare Road**
**Halifax**
**HX1 2HY (GB)**

(56) References cited:
**EP-A- 0 997 902**        **WO-A-20/04038719**
**US-A1- 2002 071 194**     **US-A1- 2003 043 939**

**Description**

The present invention relates to frequency detector in a phase locked loop (hereinafter referred to as "PLL") circuits, and to frequency error detecting methods. More particularly, but not exclusively the present invention relates to frequency detectors and methods for detecting a frequency error in an optical disc reproducing system at high speed.

An optical disc reproducing system reproduces data from an optical disc, such as a compact disc (CD), a digital versatile disc (DVD), a Blue-Ray disc (BD), or a high-definition (HD)-DVD. The optical disc reproducing system requires a sampling clock (or a bit clock), which is synchronized with a radio-frequency (RF) signal, to reproduce the RF signal from an optical disc. In the optical disc reproducing system, the sampling clock is generated by a PLL circuit.

The PLL circuit generates a frequency error to control an oscillating frequency of a controlled oscillator of the PLL circuit. The frequency error is the difference between the frequency of a current sampling clock output from the PLL circuit and a target frequency, and is generated by a frequency detector in the PLL circuit.

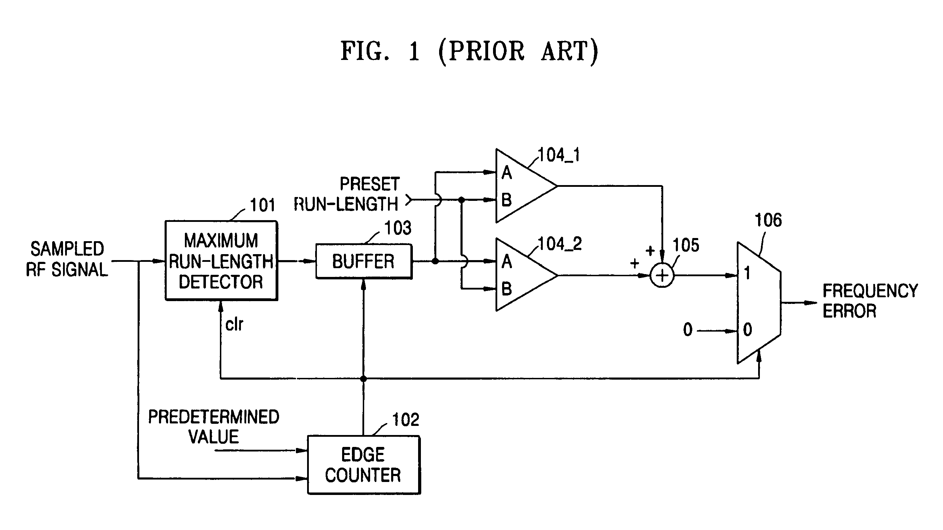

FIG. 1 illustrates a known frequency detector installed in the PLL circuit. Referring to FIG. 1, the frequency detector includes a maximum run-length detector 101, an edge counter 102, a buffer 103, first and second comparators 104_1 and 104_2, an adder 105, and a multiplexer 106. When receiving a sampled RF signal, the maximum run-length detector 101 detects a maximum run-length mark. The sampled RF signal is received from an analog-to-digital converter (ADC) (not shown) installed in the PLL circuit.

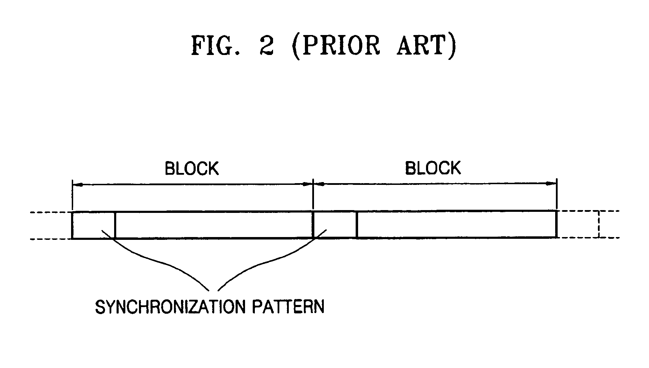

As illustrated in FIG. 2, the sampled RF signal has a series of blocks, each having a fixed length. FIG. 2 is a diagram of the series of blocks. Referring to FIG. 2, a head of each block is constructed using a synchronization pattern. The synchronization pattern includes at least one maximum run-length mark. The maximum run-length detector 101 of FIG. 1 detects a maximum run-length mark from the synchronization pattern. The edge counter 102 counts passing edges (rising edges and falling edges) of the sampled RF signal to control a frequency detection period. Thus, a predetermined value is set in the edge counter 102 such that the frequency detection period has at least a synchronization pattern.

When the counting result reaches the predetermined value, the edge counter 102 provides a positive pulse to the maximum run-length detector 101, the buffer 103, and the multiplexer 106. Then, the maximum run-length detector 101 is cleared to start detecting a maximum run-length in a subsequent frequency detection period. The buffer 103 loads the maximum run-length from the maximum run-length detector 101 and the positive pulse from the edge counter 102.

The first and second comparators 104_1 and 104_2 compare the maximum run-length loaded into the buffer 103 with a predetermined run-length. The first comparator 104_1 outputs "-1" when the maximum run-length loaded into the buffer 103 is greater than the predetermined run-length, and outputs "0" otherwise. The second comparator 104_2 outputs "+1" when the loaded maximum run-length is less than the predetermined run-length, and outputs "0" otherwise. The predetermined run-length is a maximum run-length.

The maximum run-length loaded into the buffer 103 is greater than the predetermined run-length when a sampling clock frequency of the sampled RF signal is greater than a target frequency. In this case, the adder 105 outputs "-1". The maximum run-length loaded into the buffer 103 is less than the predetermined run-length when the sampling clock frequency of the sampled RF signal is less than the target frequency. In this case, the adder 105 outputs "+1". If the maximum run-length loaded into the buffer 103 is equal to the predetermined run-length, the adder 105 outputs "0". Whenever receiving a positive pulse from the edge counter 102, the multiplexer 106 outputs an output of the adder 105 as a frequency error.

As described above, the frequency detector illustrated in FIG. 1 detects a maximum run-length mark from a synchronization pattern and generates a frequency error. However, a maximum run-length is not detected often. For instance, one or two maximum run-length marks may be detected from each block illustrated in FIG. 2. Accordingly, a frequency detection period controlled by the edge counter 102 must be set such that at least a maximum run-length mark is detected therein. Thus, there is a drawback in reducing a frequency error detection period when using the frequency detector of FIG. 1, thereby preventing a frequency error from being detected at high speed.

Also, a maximum run-length may be affected by noise or inter-symbol interference (ISI). Thus, the performance of the frequency detector of FIG. 1 may degrade in an environment where a signal-to-noise ratio (SNR) is low and/or inter-symbol interference (ISI) is high.

Accordingly, when using a PLL circuit with the frequency detector of FIG. 1 in an apparatus such as a high-density optical disc reproducing system in which the SNR is low and the ISI is high, the performance of the frequency detector may not be adequate.

WO 2004/038719 describes a frequency and phase control apparatus includes an analog/digital conversion section for converting a reproduction signal into a multiple bit digital signal based on a clock signal; a maximum likelihood decoding section for converting the multiple bit digital signal into a binary signal; a pattern detection section for detecting a pattern of the binary signal; and a determination section for determining whether or not the multiple bit digital signal and the clock signal are in synchronization with each other based on the detection result. When the determination result of the determination sections indicates that the multiple bit digital signal and the clock signal are in synchronization with each other, the maximum likelihood decoding section generates a binary signal based on a first state transition rule; otherwise, the maximum likelihood decoding section generates a binary signal based on a second state transition rule.

It is an aim of preferred embodiments of the present invention to provide a frequency detector in a PLL circuit and a frequency error detecting method, which are capable of precisely detecting a frequency error even under an environment in which a signal-to-noise ratio (SNR) is low and inter-symbol interference (ISI) is high.

According to the present invention there is provided an apparatus and method as set forth in the appended claims. Preferred features of the invention will be apparent from the dependent claims, and the description which follows.

FiG. 1 is a block diagram of a known frequency detector;

FIG. 2 is a block diagram of a series of blocks;

FIG. 3 is a block diagram of a frequency detector according to an embodiment of the present invention;

FIG. 4 is a graph illustrating a run-length distribution density estimated according to channel coding characteristics of an optical disc reproducing system, useful with embodiments of the present invention;

FIG. 5 is a graph illustrating a run-length distribution density versus a run-length region divided by a run-length region boundary value, useful with embodiments of the present invention;

FIG. 6 is a detailed block diagram of the run-length signal detecting unit of FIG. 3;

FIG. 7 is a graph illustrating a run-length distribution density versus a run-length region divided by a predetermined boundary value when the frequency of a sampling clock of an optical disc reproducing system, which is output from a PLL circuit, is less than a target frequency;

FIG. 8 is a graph illustrating the relationship between an actual number of run-length signals, a predicted number thereof, and a threshold based on the predicted number in each run-length region in the run-length distribution density of FIG. 7;

FIG. 9 is a graph illustrating a run-length distribution density versus a run-length region divided by a predetermined boundary value when the frequency of a sampling clock of an optical disc reproducing system, which is output from a PLL circuit, is greater than a target frequency;

FIG. 10 is a graph illustrating the relationship between an actual number of run-length signals, a predicted number thereof, and a threshold based on the predicted number in each run-length region in the run-length distribution density of FIG. 9;

FIG. 11 is a detailed block diagram of a frequency-error generating unit of FIG. 3;

FIG. 12 is a block diagram of a frequency detector according to another embodiment of the present invention;

FIG. 13 is a detailed block diagram of a run-length signal detecting unit of FIG. 12;

FIG. 14 is a detailed block diagram of a frequency-error generating unit of FIG. 12;

FIG. 15 is a flowchart illustrating a method of detecting a frequency error according to another embodiment of the present invention;

FIG. 16 is a flowchart illustrating a method of detecting a frequency error according to yet another embodiment of the present invention; and

FIG. 17 is a block diagram of a recording and/or reproducing apparatus according to an embodiment of the present invention.

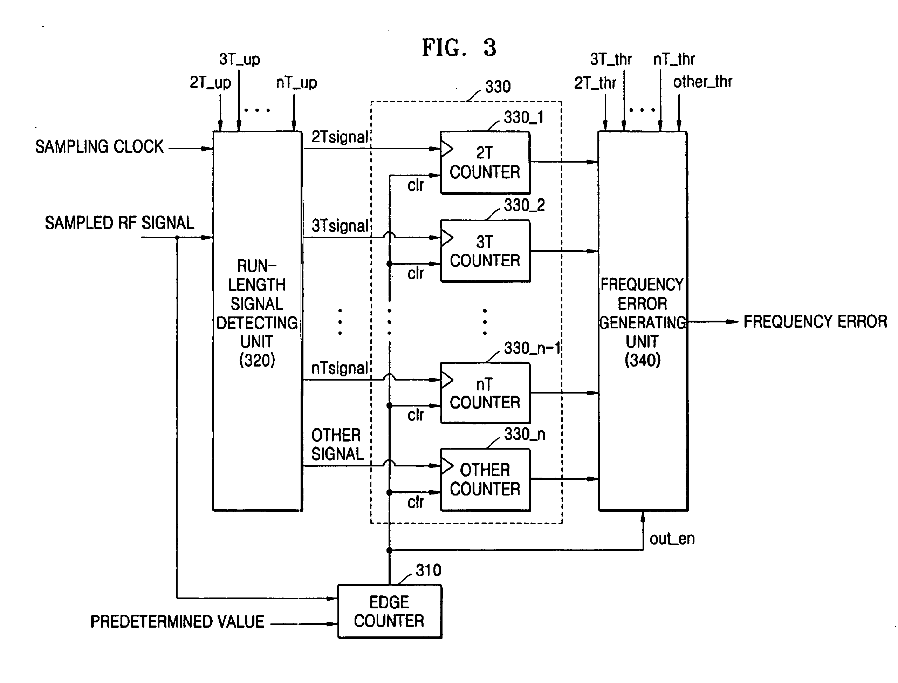

FIG. 3 is a block diagram of a frequency detector according to an embodiment of the present invention. Referring to FIG. 3, the frequency detector includes an edge counter 310, a run-length signal detecting unit 320, a counter unit 330, and a frequency-error generating unit 340. A sampled radio-frequency (RF) signal may be received from an analog-to-digital converter (ADC) (not shown) installed in a PLL circuit (not shown) with the frequency detector of FIG. 3. Alternately, the RF signal can be received from a signal processing circuit, (such as a DC component remover) which is connected to an output terminal of the ADC. The ADC samples an input RF signal and outputs the sampled RF signal.

Upon receiving the sampled RF signal, the edge counter 310 counts passing edges of the sampled RF signal to control a frequency detection period. The passing edges include rising edges and falling edges of the sampled RF signal. When the counting result reaches a predetermined value, the edge counter 310 outputs a signal having a positive pulse to control the frequency detection period. Also, after outputting the signal with the positive pulse, the edge counter 310 clears the counting result and counts passing edges of a subsequently sampled RF signal to control a subsequent frequency detection period. When the counting result does not reach the predetermined value, the edge counter 310 outputs "0". The signal with the positive pulse is transmitted to the counter unit 330 and the frequency-error generating unit 340.

If the predetermined value is a large value, the accuracy of the counting result is increased but a speed of detecting a frequency error is reduced. In contrast, if the predetermined value is a small value, the accuracy of the counting result is low but the speed of detecting a frequency error is increased. Accordingly, the predetermined value is suitably determined based on a range that allows evaluation of the distribution density of a run-length signal versus the sample RF signal.

The run-length signal detecting unit 320 detects run-length signals from the RF signal that is sampled based on the distribution density of the run-length estimated according to channel coding characteristics of the optical disc reproducing system. Specifically, the run-length signal detecting unit 320 partitions the sampled RF signal into at least two run-length regions. The partition is based on the estimated run-length distribution density. The run-length signal detecting unit 320 then classifies and detects run-length signals of the RF signals sampled in the frequency detection period according to the corresponding run-length regions.

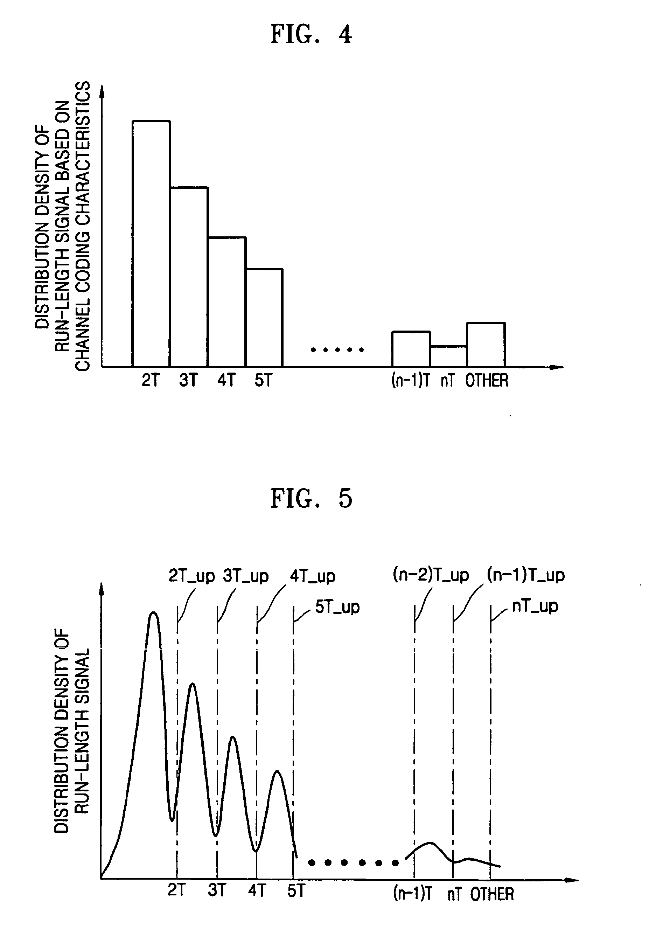

In the shown embodiment, the run-length signal detecting unit 320 divides the run-length region by 1T into n-1 run-length regions from a 2T run-length region to an nT run-length, and other run-length regions including run-lengths except 2T through nT run-lengths. In other words, assuming the distribution density of the run-length estimated according to the channel coding characteristics of the optical disc reproducing system as illustrated in FIG. 4, the run-length signal detecting unit 320 divides the run-length region into n run-length regions, using a predetermined run-length region boundary value 2T_up, 3T_up, ..., nT_up, as illustrated in FIG. 5.

Here, n may be determined based on a maximum run-length of the various types of optical discs available in an optical disc reproducing system in which the frequency detector is to be used. For instance, when a compact disc (CD), a digital versatile disc (DVD), a blue-ray disc (BD), and a high-definition (HD)-DVD are available in the optical disc reproducing system, a maximum run-length of the CD is 11T, a maximum run-length of the DVD is 11T, a maximum run-length of the BD is 8T, and a maximum run-length of the HD-DVD is 11T. Therefore, n may be set to 11. Further, if compatibility is not needed with plural media, n can be set for only that media.

According to another embodiment, the run-length signal detecting unit 320 divides the run-length region into a run-length region corresponding to a minimum run-length (e.g., 2T) and a run-length region that covers all the other run-lengths except the minimum run-length, and detects the run-length signal from the sampled RF signal. According to another embodiment, the run-length signal detecting unit 320 divides the run-length region into a run-length region corresponding to a run-length in which a run-length signal is most frequently detected, and a run-length region that covers the other run-lengths except the most frequently detected run-length signal, and detects a run-length signal from the sampled RF signal. Although FIGs. 4 and 5 illustrate that the minimum run-length 2T is a most frequently detected run-length, a run-length, other than the minimum run-length 2T may be the most frequently detected run-length according to other embodiments.

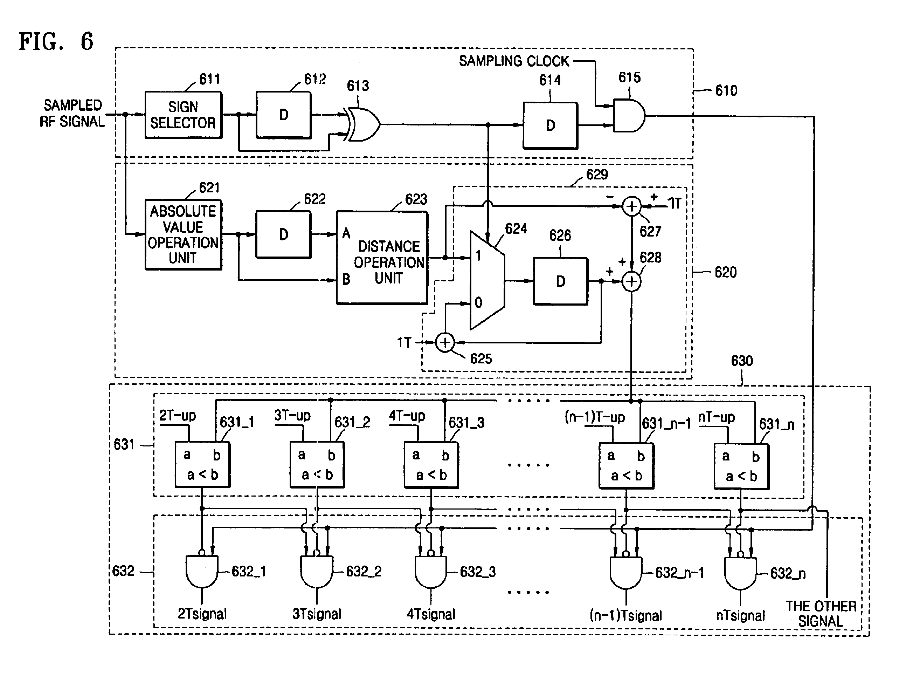

An example of the run-length signal detecting unit 320 is constructed as illustrated in FIG. 6. Referring to FIG. 6, the run-length signal detecting unit 320 includes a zero-crossing point detecting unit 610, a run-length signal detection unit 620, and an enable signal generating unit 630. The zero-crossing point detecting unit 610 detects a zero crossing point of a sampled RF signal. As shown, the zero-crossing point detecting unit 610 includes a sign selector 611, a first delayer 612, an XOR gate 613, a second delayer 614, and an AND gate 615. The sign selector 611 transforms the sample RF signal into a rectangular shaped signal. That is, the sign selector 611 outputs "1" when the sampled RF signal is positive, and outputs "0" when the sampled RF signal is negative. The first delayer 612 delays an output of the sign selector 611 by a sampling clock. The XOR gate 613 performs an exclusive or operation on outputs of the sign selector 611 and the first delayer 612, and outputs "1" when the sampled RF signal has a zero crossing point. The second delayer 614 delays an output of the XOR gate 613 by the sampling clock. The AND gate 615 performs an AND operation on the sampling clock of the optical disc reproducing system, which is output from the PLL circuit, and an output of the second delayer 614. The AND gate 615 outputs a signal with a rising edge when the sampled RF signal has a zero crossing point.

The run-length signal detection unit 620 detects a run-length signal from the sampled RF signal. Referring to FIG. 6, the run-length signal detection unit 620 includes an absolute value operation unit 621, a third delayer 622, a distance operation unit 623, a multiplexer 624, a first adder 625, a fourth delayer 626, a subtracter 627, and a second adder 628. The absolute value operation unit 621 computes an absolute value of the sampled RF signal. The third delayer 622 delays an output of the absolute value operation unit 621 by the sampling clock. The distance operation unit 623 computes a distance d between sampled points, using the output of the absolute value operation unit 621 and an output of the third delayer 622. That is, assuming that the one-sampling clock delayed absolute value output from the third delayer 622 is A and the non-delayed absolute value output from the absolute value operation unit 621 is B, the distance operation unit 623 computes the distance d using the following equation:

$$d = \left[\frac{B}{A+B} \times T\right] \quad \dots (1),$$

where T is a fixed integer that denotes a period of the sampling clock.

The multiplexer 624 transmits an output of the distance operation unit 623 at the zero crossing point, under control by the output of the XOR gate 613. At a point, not the zero crossing point, the multiplexer 624 transmits a signal received from the first adder 625. The fourth delayer 626 delays an output of the multiplexer 624 by the sampling clock. The first adder 625 adds 1T to the output of the multiplexer 624 and transmits the addition result to the multiplexer 624 at the point, other than the zero crossing point.

The subtracter 627 subtracts the output of the distance operation unit 623 from 1T. The second adder 628 adds an output of the subtracter 627 to an output of the fourth delayer 626. The addition result corresponds to the run-length signal detected from the sampled RF signal. The multiplexer 624, the first adder 625, the fourth delayer 626, the subtracter 627, and the second adder 628 may be defined as a logic circuit 629 that detects the run-length signal by summing up 1T between zero crossing points using the outputs of the XOR gate 613 and the distance operation unit 623.

Referring to FIG. 6, the enable signal generating unit 630 generates an enable signal for a run-length region corresponding to the detected run-length signal, using a signal output from the zero-crossing point detecting unit 610, a signal output from the run-length signal detection unit 620, and the predetermined run-length region boundary value 2T_up, 3T_up, ..., nT_up. To generate the enable signal, as illustrated in FIG. 6, the enable signal generating unit 630 includes a comparison array 631 and an AND gate array 632. However, other arrays can be used in other embodiments of the invention and according to other run-length region definitions.

The comparison array 631 compares the signal output from the run-length signal detecting unit 620 with the predetermined run-length region boundary value 2T_up, 3T_up, ..., nT_up using a plurality of comparators 631_1 through 631_n. The comparison array 631 primarily checks the run-length region corresponding to the detected run-length signal according to the comparison result. For instance, if the run-length signal detected by the run-length signal detecting unit 620 is generated between 2T and 3T, the logic level of a signal output from the comparator 631_1 is different from those of signals output from the other comparators 631_2 through 631_n. If the run-length signal detected by the run-length signal detection unit 620 is generated between 3T and 4T, the logic levels of the signals output from the comparators 631_1 and 631_2 are different from those of the signals output from the other comparators 631_3 through 631_n.

The AND gate array 632 generates an enable signal for the run-length region corresponding to the run-length signal detected by the run-length signal detection unit 620. Specifically, the AND gate array 632 generates the enable signal by performing an AND operation on a signal output from a corresponding comparator of the comparison array 631, the signal output from the zero-crossing point detecting unit 610, and a signal output from a comparator adjacent to the corresponding comparator, using a plurality of AND gates 632_1 through 632_n. For instance, when the run-length signal detected by the run-length signal detection unit 620 is generated between 2T and 3T, the signal output from the comparator 631_1 is at a logic high level and the signal output from the comparator 631_2 is at a logic low level. In this case, when the OR gate 615 of the zero-crossing point detecting unit 610 outputs a signal with a rising edge, only a 3T signal output via the AND gate 632_2 of the AND gate array 632 has a positive pulse.

As another example, when the run-length signal detected by the run-length signal detection unit 620 is generated between 3T and 4T, the signals output from the comparators 631_1 and 631_2 are at a logic high level and the signal output from the comparator 631_3 is at a logic low level. In this case, when the OR gate 615 of the zero-crossing point detecting unit 610 outputs a signal with a rising edge, only a 4T signal output via the AND gate 632_3 of the AND gate array 632 has a positive pulse.

In this case, unlike the AND gates 632_2 through 632_n, the AND gate 632_1 corresponding to a 2T signal does not consider the output of the comparator adjacent to the corresponding comparator. A run-length region boundary value set in the comparator adjacent to the corresponding comparator is smaller than that set in the corresponding comparator. For instance, in the case of the AND gate 632_2, the corresponding comparator is the comparator 631_2 and the adjacent comparator is the comparator 631_1.

Enable signals output from the enable signal generating unit 630 are transmitted to the counter unit 330. The counter unit 330 includes at least a counter that counts the run-length signal detected by the run-length signal detecting unit 320 during a frequency detection period. Referring to FIG. 3, the counter unit 330 includes n counters 330_1 through 330_n, since the run-length signal detecting unit 320 uses n run-length regions. Accordingly, a total number of counters to be installed in the counter unit 330 is determined by a total number of run-length regions available in the run-length signal detecting unit 320.

Referring to FIG. 3, run-length regions available in the run-length signal detecting unit 320 include n-1 run-length regions, from a 2T run-length region to an nT run-length region, which are divided into 1T units, except the 2T to nT run-lengths. Therefore, the n counters 330_1 through 330_n include a 2T counter 330_1 corresponding to a 2T run-length, a 3T counter 330_2 corresponding to a 3T run-length, ..., an nT counter 330_n-1 corresponding to an nT run-length, and the other counter 330_n corresponding to a run-length except the 2T to nT run-lengths.

The 2T counter 330_1 counts up whenever the run-length signal detecting unit 320 outputs a 2T signal having a positive pulse. The 3T counter 330_2 counts up whenever the run-length signal detecting unit 320 outputs a 3T signal having a positive pulse. The nT counter 330_n-1 counts up whenever the run-length signal detecting unit 320 outputs an nT signal having a positive pulse. The other counter 330_n counts up whenever the run-length signal detecting unit 320 outputs the other signal having a positive pulse.

When the edge counter 310 outputs a signal having a positive pulse to the counter unit 330, count values of the 2T through the other counters 330_1 through 330_n are cleared. The count value of the 2T counter 330_1 indicates the number of 2T run-length signals generated during the frequency detection period. The count value of the 3T counter 330_2 indicates the number of 3T run-length signals generated during the frequency detection period. The count value of the nT counter 330_n-1 indicates the number of nT run-length signals generated during the frequency detection period. The count value of the other counter 330_n indicates the number of other run-length signals generated during the frequency detection period.

When the run-length signal detecting unit 320 uses two run-length regions, the counter unit 330 may include two counters, each corresponding to each of the two run-length regions, and operate as described above.

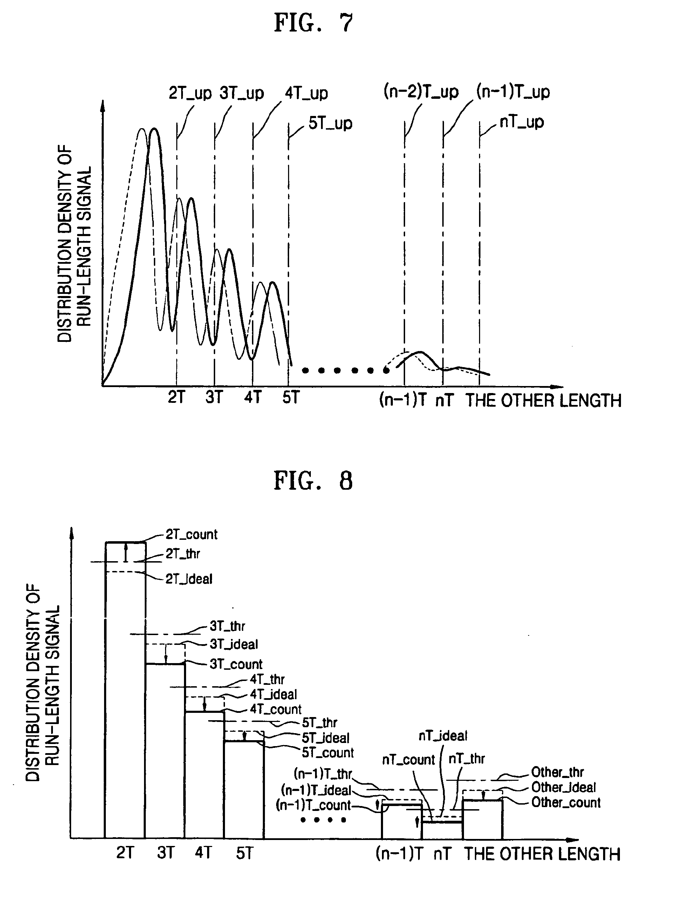

The frequency-error generating unit 340 generates a frequency error in the frequency detection period, using the count values of the n counters 330_1 through 330_n of the counter unit 330 and predetermined reference values 2T_thr through other_thr. Each of the predetermined reference values 2T_thr through other_thr is a threshold that is determined based on an estimated distribution density of a run-length signal that can be generated in a corresponding run-length region in the frequency detection period. That is, when the frequency of a sampling clock of an optical disc reproducing system, which is output from the PLL circuit, is lower than a target frequency, a graph shown in FIG. 5 (which illustrates the distribution density of a run-length signal in each of run-length regions, which are divided based on the predetermined run-length region boundary values 2T_up, 3T_up, ..., nT_up) shifts to the left side of the graph as indicated by a dotted line in FIG. 7. Thus, as illustrated in FIG. 8, except for a number 2T_count of run-length signals generated in the 2T run-length region, numbers (or run-length distribution densities) 3T_count through nT_count and other_count of the other run-length signals generated in the other run-length regions may be less than predicted numbers (or predicted run-length distribution densities) 3T_ideal through nT_ideal and other_ideal of the other run-length signals.

For this reason, a frequency error is detected using the thresholds 2T_thr through other_thr, which are slightly larger than the predicted numbers (or predicted run-length distribution densities) 2T_ideal through nT_ideal and other_ideal. FIG. 8 is a graph illustrating the relationship between an actual number nT_count of run-length signals generated in each run-length region, a predicted number nT_ideal of the run-length signals, and a threshold nT_thr determined based on the predetermined number nT_ideal, when the distribution density of the run-length signal changes as illustrated in FIG. 7.

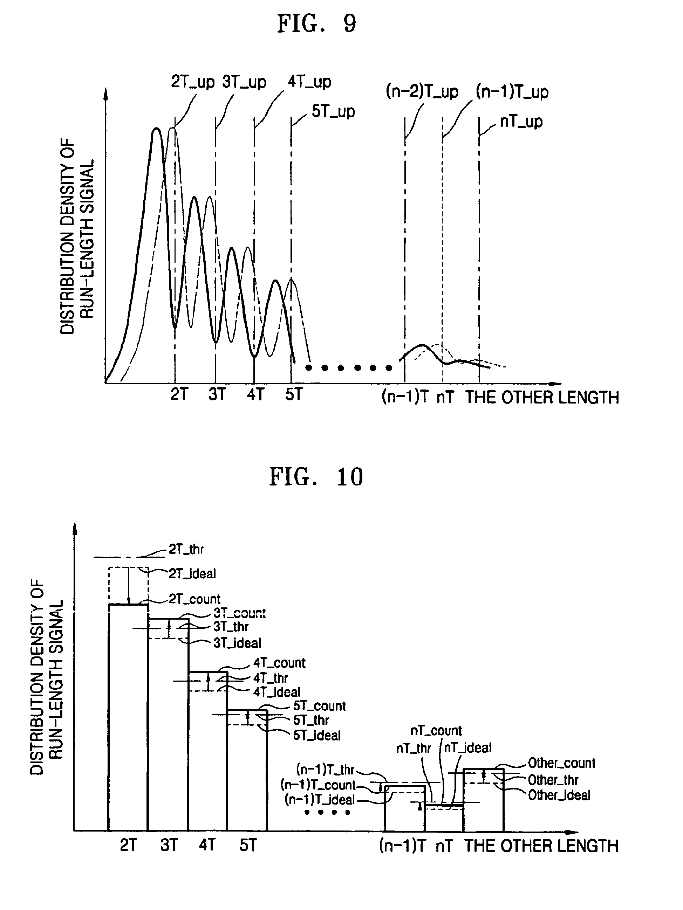

On the other hand, when the frequency of the sampling clock, output from the PLL circuit, for an optical disc reproducing system is higher than the target frequency, the graph shown in FIG. 5 shifts to the right side of the graph, as indicated by dotted lines in FIG. 9. FIG. 10 is a graph illustrating the relationship between an actual number nT_count of run-length signals generated in each run-length region, a predicted number nT_ideal of the run-length signals, and a threshold nT_thr determined based on the predetermined number nT_ideal, when the distribution density of the run-length signal in each run-length region changes as illustrated in FIG. 9. As illustrated in FIG. 10, the actual number nT_count may be less than the predicted number nT_ideal in a run-length region corresponding to a short run-length, e.g., 2T, and the actual number nT_count may be greater than the threshold nT_thr that is determined based on the predicted number nT_ideal in a run-length region corresponding to a run-length greater than 2T.

The predetermined reference value may be determined, based on the threshold that is described with reference to FIGs. 7 through 10 and the actual number of run-length signals generated.

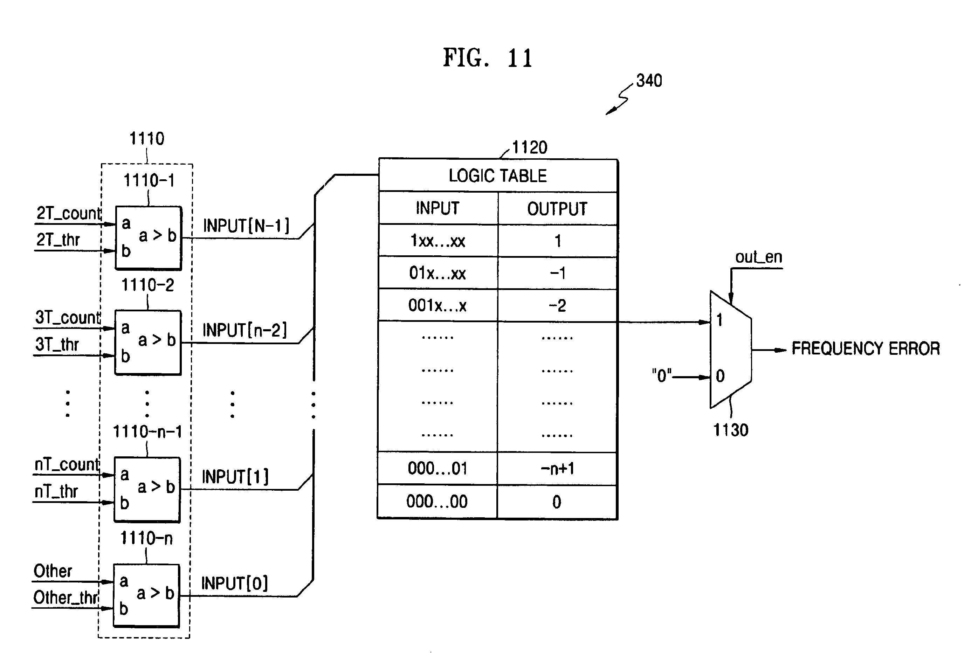

FIG. 11 is a detailed diagram of the frequency-error generating unit 340 according to an embodiment of the present invention. Referring to FIG. 11, the frequency-error generating unit 340 includes a comparison array 1110, a logic table 1120, and a multiplexer 1130. The comparison array 1110 includes a plurality of comparators 1110_1 through 1110_n that correspond to the plurality of the counters 330_1 through 330_n of the counter unit 330, respectively. The comparators 1110_1 through 1110_n compare a counter value of each of the counters 330_1 through 330_n with the predetermined reference value 2T_thr, ..., other_thr of a corresponding run-length region. The comparators 1110_1 through 1110_n output signals input [n-1] through input [0], which are indicative of the comparison results, to the logic table 1120.

The logic table 1120 selects and outputs one of a plurality of predetermined frequency errors, in response to the signals input [n-1] through input [0]. As illustrated in FIG. 11, the logic table 1120 has a structure by connecting each combination of bits that can be generated according to the comparison results output from the comparison array 1110 and a frequency error corresponding to each combination of bits. A frequency error output from the logic table 1120 is transmitted to the multiplexer 1130. It is understood that the logic table 1120 can store these combinations in a memory of the logic table 1120 or can recall the logic table 1120 e.g. from another memory included in a recording and/or reproducing apparatus.

When an output enable signal *out_en* for controlling the frequency detection period from the edge counter 310 is provided, the multiplexer 1130 transmits a signal output from the logic table 1120 as a frequency error. As described above with respect to the edge counter 310, the output enable signal *out_en* is applied as a positive-pulse signal. When the output enable signal *out_en* is not provided, the multiplexer 1130 transmits "0".

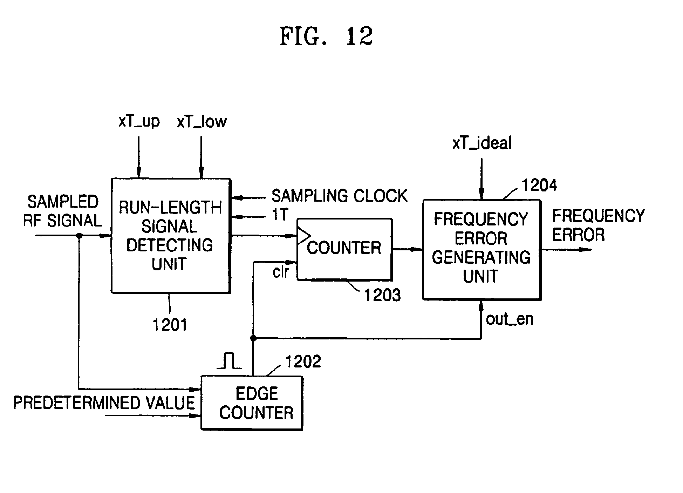

FIG. 12 is a block diagram of a frequency detector according to another embodiment of the present invention. Referring to FIG. 12, the frequency detector includes a run-length signal detecting unit 1201, an edge counter 1202, a counter 1203, and a frequency error generating unit 1204. The run-length signal detecting unit 1201 detects a high-frequency run-length signal from a sampled RF signal, based on the predicted distribution density of the run-length signal according to the channel coding characteristics of an optical disc reproducing system, which is described with reference to FIG. 3.

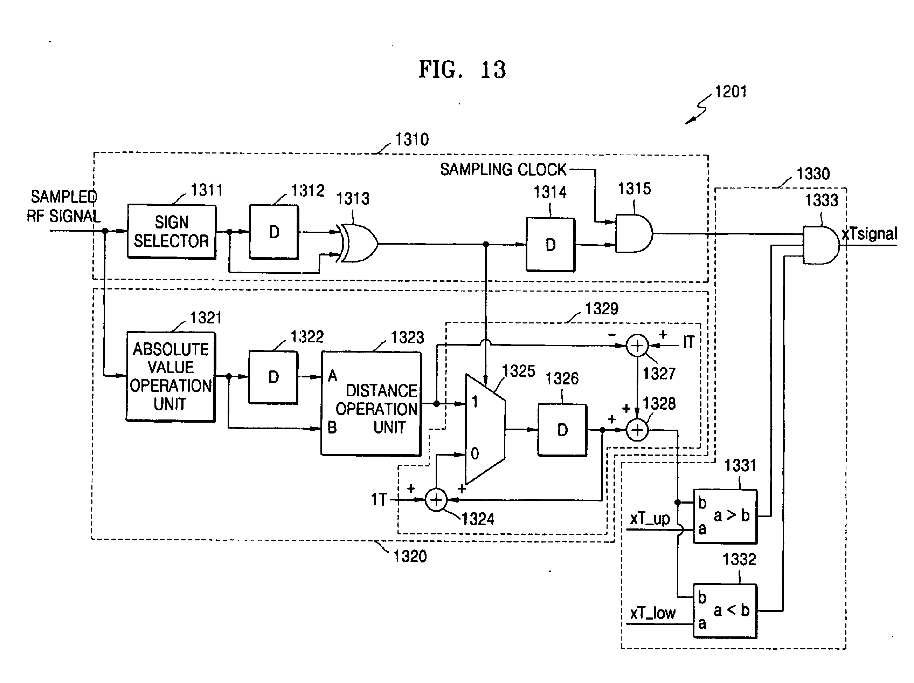

The run-length signal detecting unit 1201 is constructed as illustrated in FIG. 13. FIG. 13 is a detailed block diagram of the run-length signal detecting unit 1201 according to an embodiment of the present invention. Referring to FIG. 13, the run-length signal detecting unit 1201 includes a zero crossing point detecting unit 1310, a run-length signal detection unit 1320, and an enable signal generating unit 1330. The zero crossing point detecting unit 1310 detects a zero crossing point of the sampled RF signal. The zero crossing point detecting unit 1310 includes a sign selector 1311, a first delayer 1312, an XOR gate 1313, a second delayer 1314, and an AND gate 1315. The construction of the zero crossing point detecting unit 1310 is similar to that of the zero-crossing point detecting unit 610 of FIG. 6 in the shown embodiment.

The run-length signal detection unit 1320 detects the run-length signal from the sampled RF signal. The run-length signal detection unit 1320 includes an absolute value operation unit 1321, a delayer 1322, a distance operation unit 1323, and a logic circuit 1329. The construction of the run-length signal detection unit 1320 is similar to that of the run-length signal detection unit 620 of FIG. 6 in the shown embodiment.

The enable signal generating unit 1330 generates an enable signal based on whether the high-frequency run-length signal is detected, using the result of comparing a least upper bound *xT_up* and a greatest lower bound *xT_low* determined based on the high frequency run-length signal with the run-length signal detected by the run-length signal detection unit 1320, and the signal output from the zero crossing point detecting unit 1310. Therefore, as illustrated in FIG. 13, the enable signal generating unit 1330 includes a first comparator 1331 that compares the least upper bound *xT_up* with an output of the run-length signal detecting unit 1320; a second comparator 1332 that compares the greatest lower bound *xT_low* with the output of the run-length signal detection unit 1320; and an AND gate 1333 that performs an AND operation on outputs of the zero crossing point detecting unit 1310 and the first and second comparators 1331 and 1332 and outputs an enable signal *xTsignal* as the operation result.

For instance, if a run-length in which the run-length signal is generated most frequently, is 2T, the least upper bound *xT_up* and the greatest lower bound *xT_low* may be set to 2.5T and 0, respectively. If the run-length in which the run-length signal is generated most frequently is greater than 2T, the least upper bound *xT_up* may be set to a very large value or an infinite value, and the greatest lower bound *xT_low* may be set to 2.5T.

The operation of the edge counter 1202 is the same as that of the edge counter 310 of FIG. 3 in the shown embodiment. The counter 1203 counts run-length signals detected by the run-length signal detecting unit 1201 in the frequency detection period, and transmits the counting result to the frequency error generating unit 1204. The counting result of the counter 1203 is cleared by the edge counter 1202. The frequency error generating unit 1204 generates a frequency error in the frequency detection period, using the counting result output from the counter 1203 and a predetermined predicted value.

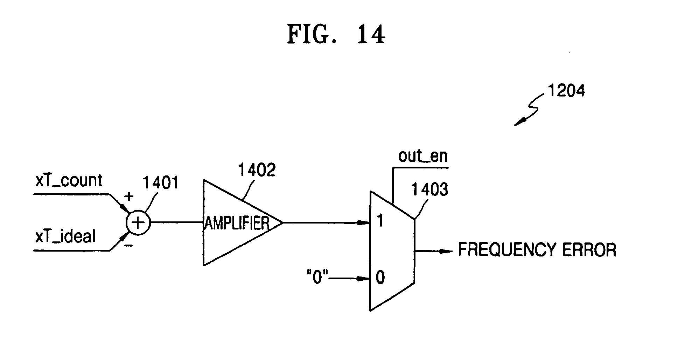

FIG. 14 is a detailed circuit diagram of the frequency error generating unit 1204 for use in an embodiment of the present invention. Referring to FIG. 14, the frequency error generating unit 1204 includes a subtracter 1401, an amplifier 1402, and a multiplexer 1403. The subtracter 1401 subtracts a counter value *xT_count,* which is output from the counter 1203, from a predetermined predicted value *xT_ideal.* The counter value *xT_count* indicates a number of high-frequency run-length signals generated in the frequency detection period. The predetermined predicted value indicates a predicted number *xT_ideal* (or a predicted distribution density) of run-length signals generated in a run-length region corresponding to a run-length in which a run-length signal is generated most frequently. The predetermined predicted value may be defined as a predetermined reference value that is different from the predetermined reference value described with respect to FIG. 3.

The amplifier 1402 amplifies the subtracting result output from the subtracter 1401 to a predetermined value according to a predetermined gain. When an output enable signal *out_en* for controlling the frequency detection period from the edge counter 1202 is provided, the multiplexer 1403 transmits an output of the amplifier 1402 as a frequency error. The output enable signal *out_en* may be a positive pulse signal. The multiplexer 1403 outputs "0" when the output enable signal *out_en* is not provided.

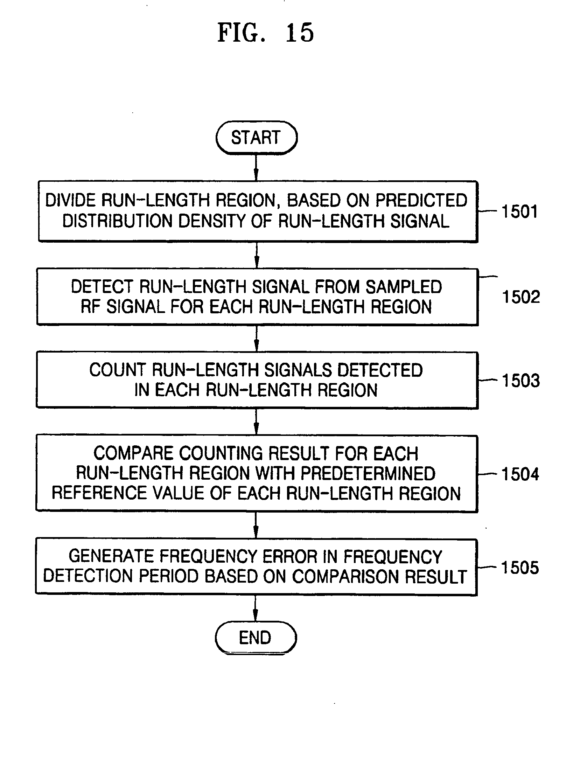

FIG. 15 is a flowchart illustrating a method of detecting a frequency error according to another embodiment of the present invention. Referring to FIGs. 3 and 15, as described above with respect to the run-length signal detecting unit 320 of FIG. 3, a run-length region in which a run-length signal can be detected, is divided into at least two run-length regions, based on the distribution density of the run-length signal which is predicted according to the channel coding characteristics of an optical disc reproducing system (1501). A run-length signal is detected from a sampled RF signal by each run-length region (1502). Run-length signals detected are counted in each run-length region, as described above with reference to the counter unit 330 of FIG. 3 (1503). A frequency error in a frequency detection period is selected and output from a plurality of predetermined frequency errors, based on a comparison of the counting result for each run-length region and a predetermined reference value for each run-length (1504 and 1505). The predetermined reference value is equal to the predetermined reference value used by the frequency-error generating unit 340 of FIG. 3.

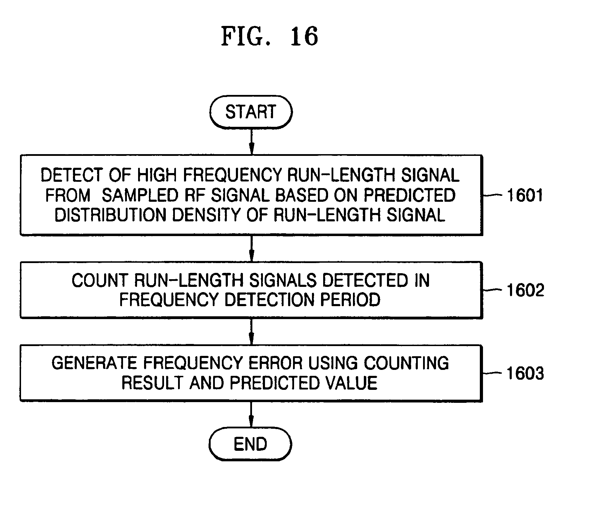

FIG. 16 is a flowchart illustrating a method of detecting a frequency error according to another embodiment of the present invention. Referring to FIGs. 12 and 16, as described above with respect to the run-length signal detecting unit 1201 of FIG. 12, a run-length signal of high frequency is detected from a sampled RF signal, based on the distribution density of a run-length signal predicted according to the channel coding characteristics of an optical disc reproducing system (1601). A number of run-length signals of high frequency detected in the frequency detection period, is counted, as described above with reference to the counter 1203 of FIG. 12 (1602). A frequency error in the frequency detection period is generated, using the counting result and a predicted value of the run-length signal of high frequency (1603). The frequency error is generated by subtracting the counting result from the predicted value, as described above with respect to the frequency error generating unit 1204 of FIG. 12.

It is understood that the values used by the logic table 1120, the thresholds *2T_thr, ..., other_thr,* and other predetermined numbers can be adjusted and/or updated according to usage of the apparatus and/or through software updates in order to increase the accuracy of the frequency error detection and/or the predicted distribution density.

A program that executes a method of detecting a frequency error according to the present invention can be embodied as computer readable code in at least one computer readable medium. Here, the computer readable medium may be any recording apparatus capable of storing data that is read by a computer system, e.g., read-only memory (ROM), random access memory (RAM), a compact disc (CD)-ROM, a magnetic tape, a floppy disk, an optical data storage device, and so on. Also, the computer readable medium may be a carrier wave that transmits data via the Internet, for example. The computer readable medium can be distributed among computer systems that are interconnected through a network, and the present invention may be stored and implemented as a computer readable code in the distributed system.

As described above, according to the present invention, a frequency error is generated by collecting run-length information from an RF signal sampled based on the distribution density of a run-length signal, which is predicted according to the channel coding characteristics of an optical disc reproducing system. Accordingly, it is possible to more rapidly detect a frequency error than when using a conventional method.

Also, a frequency error is generated by collecting information regarding a run-length in which a run-length signal is detected more frequently, as run-length information regarding the sampled RF signal, based on the predicted distribution density of the run-length signal, thereby realizing a frequency detector that is less sensitive to noise and inter-symbol interference (ISI). Accordingly, it is possible to improve the frequency error detecting performance of a PLL circuit in a system, such as a high-density optical disc reproducing system, which has low noise characteristics and high ISI characteristics.

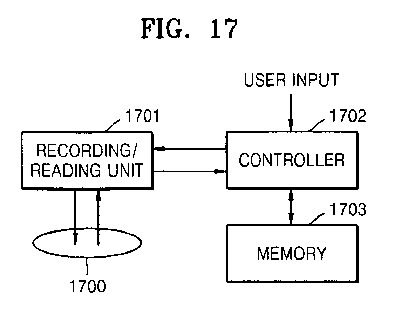

FIG. 17 is a block diagram of a recording and/or reproducing apparatus according to an embodiment of the present invention. Referring to FIG. 17, the recording apparatus includes a recording/reading unit 1701, a controller 1702, and a memory 1703. The recording/reading unit 1701 records data on a disc 1700, and reads the data from the disc 1700. The controller 1702 records and reproduces disc related data using the PLL circuit according to the present invention as set forth above in relation to FIGs. 3 through 16.

In certain embodiments, the controller 1702 can be computer implementing the method using a computer program encoded on a computer readable medium. The computer can be implemented as a chip having firmware, or can be a general or special purpose computer programmable to perform the method.

In addition, it is understood that, in order to achieve a recording capacity of several dozen gigabytes, the recording/reading unit 1701 could include a low wavelength, high numerical aperture type unit usable to record dozens of gigabytes of data on the disc 1700. Examples of such units include, but are not limited to, those units using light wavelengths of 405 nm and having numerical apertures of 0.85, those units compatible with Blu-ray discs, and/or those units compatible with Advanced Optical Discs (AOD).

## Claims

1. A frequency detector in an optical disc reproducing system, comprising:

a run-length signal detecting unit (320) which detects run-length signals from a sampled radio-frequency signal in a frequency detection period, based on a predicted distribution density of run-length signals;

a counter unit (330) including at least one counter (330_1-330_n) which counts the detected run-length signals in the frequency detection period;

an edge counter (310) which counts passing edges of the sampled radio-frequency signal to control the frequency detection period; and

a frequency error generating unit (340) which generates a frequency error in the frequency detection period, using the counting result output from the at least one counter (330_1-330_n) and a predetermined reference value.

2. The frequency detector of claim 1, wherein the run-length signal detecting unit (320) detects the run-length signals from the sampled RF signal according to corresponding run-length regions into which the run-length signals are divided based on the predicted distribution density.

3. The frequency detector of claim 1 or 2, wherein each of the run-length regions corresponds to at least one xT run-length, where x is an integer from 2 to n, and n is determined according to maximum run-lengths of various types of discs compatible with the optical disc reproducing system.

4. The frequency detector of claim 3, wherein the run-length regions further comprise at least one other run-length which covers run-lengths except the 2T to nT run-lengths.

5. The frequency detector of any one of claims 1-4, wherein the counter unit (330) comprises a total number of the counters equal to a number of run-length regions used by the run-length signal detecting unit.

6. The frequency detector of claim 5, wherein:

each of the counters (330_1-330_n) counts a value which corresponds to a number of run-length signals generated in the corresponding run-length region,

the predetermined reference value is a threshold determined based on the predicted distribution density of run-length signals to be generated in the corresponding run-length regions in the frequency detection period, and

the frequency error generating unit (340) generates the frequency error, based on a comparison of, for each of the run-length regions, the counter value assigned to the run-length region and the corresponding predetermined reference value.

7. The frequency detector of any preceding claim, wherein the run-length signal detecting unit (320) detects a high-frequency run-length signal from the sampled radio-frequency signal, based on the predicted distribution density of the run-length signal.

8. The frequency detector of claim 7, wherein:

the counter unit comprises a counter, the predetermined reference value corresponds to the predicted distribution density of the high-frequency run-length signal , and the frequency error generating unit generates the frequency error using a signal corresponding to a value obtained by subtracting the counter value from the predetermined reference value.

9. The frequency detector of any preceding claim, wherein the edge counter counts the passing edges using a predetermined value which is determined based on a range which allows evaluation of the distribution density of the run-length signals with respect to the sampled RF signal.

10. The frequency detector of claim 1, 2, 3 or 4, wherein the run-length signal detecting unit (320) comprises:

a zero crossing point detecting unit (610) arranged to detect a zero crossing point of the sampled radio-frequency signal;

a run-length signal detection unit (620) arranged to detect the run-length signal from the sampled radio-frequency signal; and

an enable signal generating unit (630) which generates an enable signal for the run-length region corresponding to the detected run-length signal using a signal output from the zero crossing point detecting unit (610), a signal output from the run-length signal detecting unit (620), and a predetermined run-length region boundary value; and outputs the enable signal to the counter unit (330) corresponding to the run-length region of the detected run-length signal.

11. The frequency detector of claim 10, wherein the zero crossing point detecting unit (610) comprises:

a sign selector (611) which transforms the sampled radio-frequency signal into a rectangular shaped signal;

a first delayer (612) which delays an output of the sign selector (611);

an XOR gate (613) performing an XOR operation on the output of the sign selector (611) and an output of the first delayer (612);

a second delayer which delays an output of the XOR gate (613); and

an AND gate (615) performing an AND operation on a sampling clock of an optical disc reproducing system and an output of the second delayer (614).

12. The frequency detector of claim 11, wherein the run-length signal detection unit (620) comprises:

an absolute value operation unit (621) which computes an absolute value of the sampled radio-frequency signal;
a third delayer (622) which delays an output of the absolute value operation unit (621);
a distance operation unit (623) which computes a distance between the sampled radio-frequency signals, using the output of the absolute value operation unit (621) and an output of the third delayer (622); and
a logic circuit (629) which accumulates 1T between zero crossing points and detects the run-length signal, using the output of the XOR gate (613) and an output of the distance operation unit (623), where 1T denotes a period of the sampling clock of the optical disc reproducing system.

13. The frequency detector of claim 12, wherein the logic circuit (629) comprises:

a multiplexer (624) which transmits the output of the distance operation unit (623) at the zero crossing point using the output of the XOR gate (613);
a fourth delayer (626) which delays an output of the multiplexer (624);
a first adder (625) which outputs a sum of 1T and an output of the fourth delayer (626) to the multiplexer so that a sum is transmitted via the multiplexer at a point other than the zero crossing point;
a subtracter (627) which subtracts the output of the distance operation unit (623) from 1T; and
a second adder (628) which adds an output of the subtracter (627) and the output of the fourth delayer (626) and outputs the addition result as the detected run-length signal.

14. The frequency detector of any one of claims 10-13, wherein the enable signal generating unit (630) comprises:

a comparison array (631) which compares the signal output from the run-length signal detection unit (620) and the predetermined run-length region boundary value using a plurality of comparators, and checks the run-length region corresponding to the detected run-length signal; and
an AND gate array (632) which performs an AND operation on a signal output from a corresponding comparator in the comparison array, the signal output from the zero crossing point detecting unit, and a signal output from a comparator adjacent to the corresponding comparator, using a plurality of AND gates; re-checks the run-length region corresponding to the detected run-length signal; and generates the enable signal according to the checked results.

15. The frequency detector of claim 1, wherein the frequency error generating unit (340) comprises:

a comparison array (1110) including a plurality of comparators which respectively correspond to the plurality of the counters and which compares a counter value of each of the counters with the predetermined threshold of the corresponding run-length region;
a logic table (1120) which selects and outputs one of a plurality of predetermined frequency errors stored in the table in response to signals output from the comparators of the comparison array; and
a multiplexer (1130) which transmits a signal output from the logic table (1120) as the frequency error when the edge counter provides an output enable signal for controlling the frequency detection period.

16. The frequency detector of claim 19, wherein the run-length signal detecting unit (1201) comprises:

a zero crossing point detecting unit (1310) which detects a zero crossing point of the sampled radio-frequency signal;
a run-length signal detection unit (1320) which detects run-length signals from the sampled radio-frequency signal; and
an enable signal generating unit (1330) which generates an enable signal based on whether the high-frequency run-length signal is detected as compared to other run-length signals, using a comparison of a least upper bound and a greatest lower bound determined based on the high-frequency run-length signal with the detected run-length signal, and a signal output from the zero crossing point detecting unit (1310).

17. The frequency detector of claim 16, wherein the frequency error generating unit (1204) comprises:

a subtracter (1401) which subtracts the counter value, which is output from the counter (1203), from the predetermined predicted value;
an amplifier (1402) which amplifies an output of the subtracter (1401) to a predetermined value; and

a multiplexer (1403) which transmits an output of the amplifier (1402) as the frequency error when the edge counter (1202) transmits an output enable signal for controlling the frequency detection period.

18. The frequency detector of claim 1, wherein the high-frequency run-length signal comprises a high-frequency run-length used in a Blue-ray type optical disc reproducing system.

19. The frequency detector of claim 1, wherein the high-frequency run-length signal comprises a high-frequency run-length used in a high definition digital versatile disc (HD-DVD) type optical disc reproducing system.

20. The frequency detector of claim 1, comprising:

a plurality of counter units (330_1-330_n) corresponding to a number of run-length regions to generate a counting result, each counter unit to count the detected run-length signals separated into the corresponding run-length region to provide a region counting result included in the counting result.

21. The frequency detector of claim 20, wherein:

the run-length regions comprise a first run-length region corresponding to run-length signals having a first length, and a second run-length region corresponding to run-length signals having a second length other than the first length,
the run-length signal detecting unit (320) separates the run-length signals having the first length into the first run-length region and the run-length signals having the second length into the second run-length region according to the detected lengths, and
the plurality of counter units comprises a first counter unit (330_1) which counts the detected run-length signals separated into the first run-length region to provide a first region counting result included in the counting result, and a second counter unit (330_n) which counts the detected run-length signals separated into the second run-length region to provide a second region counting result included in the counting result.

22. The frequency detector of claim 20, wherein:

the run-length regions include first through n run-length regions corresponding to run-length signals having first through n lengths, where n is a maximum run length includable in the radio frequency signal,

the run-length signal detecting unit (320) detects the first through n lengths of the run-length signals and separates the run-length signals into corresponding first and n run-length regions according to the detected lengths, and
the plurality of counter units (330_1-330_n) comprises first through nth counter units to generate the counting result, where the first counter unit counts the detected run-length signals separated into the first run-length region to provide a first region counting result included in the counting result, and the second through nth counter units (330_2-330-n) count the corresponding detected run-length signals separated into the second through nth run-length regions to provide corresponding second through nth region counting results included in the counting result.

23. The frequency detector of claim 22, wherein n corresponds 11 T run lengths.

24. The frequency detector of claim 22, wherein n corresponds 8T run lengths.

25. The frequency detector of claim 20, wherein the frequency error generating unit (340)compares the region counting results for the run-length regions with a preselected profile of expected region counting results to detect a comparison result, and generates the frequency error according to the detected comparison result.

26. The frequency detector of claim 25, wherein the frequency error generating unit includes:

a memory which stores, for each potential comparison result, a frequency error, and
a frequency error unit which detects the comparison, selects from the memory one of the frequency errors corresponding to the comparison result, and outputs the selected frequency error.

27. An optical recording and/or reproducing apparatus including the frequency detector of claim 22, wherein n corresponds to the maximum run length of an optical recording medium reproduced by the apparatus.

28. An optical recording and/or reproducing apparatus including the frequency detector of claim 20, wherein the number of run-length regions and the number of counter units correspond to a maximum run length of an optical recording medium reproduced by the apparatus.

29. An optical recording and/or reproducing apparatus including the frequency detector of any one of claims 1 - 26.

30. A method of detecting a frequency error suitable for use in an optical disc reproducing system, the method comprising:

dividing a run-length region, in which a run-length signal is to be detected, into at least two run-length regions based on a predicted distribution density of run-length signals (1501); detecting run-length signals from a sampled radio-frequency signal according to each divided run-length regions (1502); counting the run-length signals detected in each divided run-length region; and selecting and outputting a frequency error in a frequency detection period from a plurality of predetermined frequency errors, based on a comparison of a number of run-length signals counted in each divided run-length region and a predetermined threshold of each run-length region (1504, 1505).

**Patentansprüche**

1. Frequenzdetektor in einem Wiedergabesystem für optische Platten, umfassend:

eine Run-Length-Signal-Detektionseinheit (320), die Run-Length-Signale aus einem abgetasteten HF-Signal in einer Frequenzdetektionsperiode auf Basis einer vorausberechneten Verteilungsdichte von Run-Length-Signalen detektiert, eine Zählereinheit (330), die wenigstens einen Zähler (330_1-330_n) enthält, der die detektierten Run-Length-Signale in der Frequenzdetektionsperiode zählt, einen Flankenzähler (310), der übertragene Flanken des abgetasteten HF-Signals zählt, um die Frequenzdetektionsperiode zu steuern, und eine Frequenzfehler-Erzeugungseinheit (340), die mit Hilfe des von dem wenigstens einen Zähler (330_1-330_n) ausgegebenen Zählergebnisses und eines vorgegebenen Referenzwertes in der Frequenzdetektionsperiode einen Frequenzfehler erzeugt.

2. Frequenzdetektor nach Anspruch 1, wobei die Run-Length-Signal-Detektionseinheit (320) die Run-Length-Signale aus dem abgetasteten HF-Signal in Übereinstimmung mit entsprechenden Run-Length-Bereichen, in die die Run-Length-Signale auf Basis der vorausberechneten Verteilungsdichte aufgeteilt sind, detektiert.

3. Frequenzdetektor nach Anspruch 1 oder 2, wobei jeder der Run-Length-Bereiche wenigstens einer xT-Run-Length entspricht, wobei x eine Ganzzahl von 2 bis n ist und n entsprechend maximalen Run-Lengths von verschiedenen Platten, die mit dem Wiedergabesystem für optische Platten kompatibel sind, bestimmt wird.

4. Frequenzdetektor nach Anspruch 3, wobei die Run-Length-Bereiche des Weiteren wenigstens eine weitere Run-Length umfassen, die Run-Lengths abdeckt, ausgenommen die 2T bis nT Run-Lengths.

5. Frequenzdetektor nach einem der Ansprüche 1 bis 4, wobei die Zählereinheit (330) eine Gesamtanzahl von Zählern gleich einer Anzahl von Run-Length-Bereichen, die durch die Run-Length-Detektionseinheit verwendet werden, umfasst.

6. Frequenzdetektor nach Anspruch 5, wobei

jeder der Zähler (330_1-330_n) einen Wert zählt, der einer Anzahl von Run-Length-Signalen entspricht, die in dem entsprechenden Run-Length-Bereich erzeugt werden, der vorgegebene Referenzwert ein Schwellenwert ist, der auf Basis der vorausberechneten Verteilungsdichte von Run-Length-Signalen, die in den entsprechenden Run-Length-Bereichen in der Frequenzdetektionsperiode zu erzeugen sind, bestimmt wird, und die Frequenzfehler-Erzeugungseinheit (340) den Frequenzfehler auf Basis eines Vergleichens für jeden der Run-Length-Bereiche von dem dem Run-Length-Bereich zugewiesenen Zählerwert und dem entsprechenden vorgegebenen Referenzwert, erzeugt.

7. Frequenzdetektor nach einem der vorhergehenden Ansprüche, wobei die Run-Length-Signal-Detektionseinheit (320) aus dem abgetasteten HF-Signal auf Basis der vorausberechneten Verteilungsdichte des Run-Length-Signals ein HF-Run-Length-Signal detektiert.

8. Frequenzdetektor nach Anspruch 7, wobei

die Zählereinheit einen Zähler umfasst, der vorgegebene Referenzwert der vorausberechneten Verteilungsdichte des HF-Run-Length-Signals entspricht und die Frequenzfehler-Erzeugungseinheit den Frequenzfehler mit Hilfe eines Signals detektiert, das einem Wert entspricht, der durch Subtrahieren des Zählerwertes von dem vorgegebenen Referenzwert erhalten wird.

9. Frequenzdetektor nach einem der vorhergehenden Ansprüche, wobei der Flankenzähler die übertragenen Flanken mit Hilfe eines vorgegebenen Wertes zählt, der auf Basis eines Bereichs bestimmt wird, der Evaluierung der Verteilungsdichte der Run-Length-Signale in Bezug auf das abgetastete RF-Signal ermöglicht.

10. Frequenzdetektor nach Anspruch 1, 2, 3 oder 4, wobei die Run-Length-Signal-Detektionseinheit (320) umfasst:

   eine Nulldurchgangspunkt-Detektionseinheit (610), eingerichtet, um einen Nulldurchgangspunkt des abgetasteten HF-Signals zu detektieren,
   eine Run-Length-Signal-Detektionseinheit (620), eingerichtet, um das Run-Length-Signal aus dem abgetasteten HF-Signal zu detektieren, und
   eine Freigabesignal-Erzeugungseinheit (630), die ein Freigabesignal für den Run-Length-Bereich, der dem detektierten Run-Length-Signal entspricht, unter Verwendung einer Signalausgabe von der Nulldurchgangspunkt-Detektionseinheit (610), einer Signalausgabe von der Run-Length-Signal-Detektionseinheit (620) und eines vorgegebenen Run-Length-Bereichs-Grenzwertes erzeugt und das Freigabesignal zu der Zählereinheit (330) ausgibt, die dem Run-Length-Bereich des detektierten Run-Length-Signals entspricht.

11. Frequenzdetektor nach Anspruch 10, wobei die Nulldurchgangspunkt-Detektionseinheit (610) umfasst:

   einen Vorzeichenselektor (611), der das abgetastete HF-Signal in ein rechteckigförmiges Signal transformiert,
   einen ersten Verzögerer (612), der eine Ausgabe des Vorzeichenselektors (611) verzögert,
   ein XOR-Gatter (613), das eine XOR-Operation an dem Ausgang des Vorzeichenselektors (611) und an einem Ausgang des ersten Verzögerers (612) ausführt,
   einen zweiten Verzögerer, der eine Ausgabe des XOR-Gatters (613) verzögert, und
   ein UND-Gatter (615), das eine UND-Operation an einem Abtasttakt eines Wiedergabesystems für optische Platten und an einem Ausgang des zweiten Verzögerers (614) durchführt.

12. Frequenzdetektor nach Anspruch 11, wobei die Run-Length-Signal-Detektionseinheit (620) umfasst:

   eine Absolutwert-Operationseinheit (621), die einen Absolutwert des abgetasteten HF-Signals errechnet,
   einen dritten Verzögerer (622), der eine Ausgabe der Absolutwert-Operationseinheit (621) verzögert,

eine Abstands-Operationseinheit (623), die mit Hilfe der Ausgabe der Absolutwert-Operationseinheit (621) und einer Ausgabe des dritten Verzögerers (622) einen Abstand zwischen den abgetasteten HF-Signalen errechnet, und
eine Logikschaltung (629), die 1T zwischen Nulldurchgangspunkten akkumuliert und das Run-Length-Signal unter Verwendung der Ausgabe des XOR-Gatters (613) und einer Ausgabe der Abstands-Operationseinheit (623) detektiert, wobei 1T eine Periode des Abtasttakts des Wiedergabesystems für optische Platten bezeichnet.

13. Frequenzgenerator nach Anspruch 12, wobei die Logikschaltung (629) umfasst:

   einen Multiplexer (624), der die Ausgabe der Abstands-Operationseinheit (623) an dem Nulldurchgangspunkt mit Hilfe des Ausgangs des XOR-Gatters (613) sendet,
   einen vierten Verzögerer (626), der eine Ausgabe des Multiplexers (624) verzögert,
   einen ersten Addierer (625), der eine Summe von 1T und eine Ausgabe des vierten Verzögerers (626) an den Multiplexer ausgibt, so dass über den Multiplexer an einem Punkt, mit Ausnahme des Nulldurchgangspunktes, eine Summe ausgegeben wird,
   einen Subtrahierer (627), der die Ausgabe der Abstands-Operationseinheit (623) von 1T subtrahiert, und
   einen zweiten Addierer (628), der eine Ausgabe des Subtrahierers (627) und die Ausgabe des vierten Verzögerers (626) addiert und das Additionsergebnis als das detektierte Run-Length-Signal ausgibt.

14. Frequenzdetektor nach einem der Ansprüche 10 bis 13, wobei die Freigabesignal-Erzeugungseinheit (630) umfasst:

   ein Vergleichsfeld (631), das eine Signalausgabe von der Run-Length-Signal-Detektionseinheit (620) und den vorgegebenen Run-Length-Bereichsgrenzwert unter Verwendung einer Vielzahl von Komparatoren vergleicht und den dem detektierten Run-Length-Signal entsprechenden Run-Length-Bereich prüft und
   ein UND-Gatterfeld (632), das eine UND-Operation an einem Signal, das von einem entsprechenden Komparator in dem Vergleichsfeld ausgegeben wurde, an dem von der Nulldurchgangspunkt-Detektionseinheit ausgegebenen Signal und an einem von einem Komparator, angrenzend an den entsprechenden Komparator, ausgegebenen Signal mit Hilfe einer Vielzahl von UND-Gatter ausführt, den dem detektierten Run-Length-Signal entsprechenden Run-Length-Bereich erneut prüft und das Freigabesignal entsprechend den geprüften Ergebnissen erzeugt.

15. Frequenzdetektor nach Anspruch 1, wobei die Frequenzfehler-Erzeugungseinheit (340) umfasst:

ein Vergleichsfeld (1110), das eine Vielzahl von Komparatoren enthält, die jeweils der Vielzahl von Zählern entsprechen, und das einen Zählerwert von jedem der Zähler mit einem vorgegebenen Schwellenwert des entsprechenden Run-Length-Bereichs vergleichen, eine Logiktabelle (1120), die in Reaktion auf Signale, die von den Komparatoren des Vergleichsfeldes ausgegeben werden, eine Vielzahl von vorgegebenen Frequenzfehlern, die in der Tabelle gespeichert sind, auswählt und ausgibt, und einen Multiplexer (1130), der ein von der Logiktabelle (1120) ausgegebenes Signal als den Frequenzfehler sendet, wenn der Flankenzähler ein Ausgabe-Freigabesignal zum Steuern der Frequenzdetektionsperiode bereitstellt.

16. Frequenzdetektor nach Anspruch 19, wobei die Run-Length-Signal-Detektionseinheit (1201) umfasst:

eine Nulldurchgangspunkt-Detektionseinheit (1310), die einen Nulldurchgangspunkt des abgetasteten HF-Signals detektiert, eine Run-Length-Signal-Detektionseinheit (1320), die Run-Length-Signale aus dem abgetasteten HF-Signal detektiert, und eine Freigabesignal-Erzeugungseinheit (1330), die ein Freigabesignal, basierend darauf, ob das HF-Run-Length-Signal während der Vergleichens mit anderen Run-Length-Signalen detektiert wird, mit Hilfe eines Vergleichens einer wenigstens oberen Grenze und einer größten unteren Grenze, bestimmt auf Basis des HF-Run-Length-Signals, mit dem detektierten Run-Length-Signal und einer Signalausgabe von der Nulldurchgangspunkt-Detektionseinheit (1310) erzeugt.

17. Frequenzdetektor nach Anspruch 16, wobei die Frequenzfehler-Erzeugungseinheit (1204) umfasst:

einen Subtrahierer (1401), der den Zählerwert, der von dem Zähler (1203) ausgegeben wird, von dem vorgegebenen vorausberechneten Wert subtrahiert, einen Verstärker (1402), der eine Ausgabe des Subtrahierers (1401) auf einen vorgegebenen Wert verstärkt, und

einen Multiplexer (1403), der eine Ausgabe des Verstärkers (1402) als den Frequenzfehler sendet, wenn der Flankenzähler (1202) ein Ausgabe-Freigabesignal zum Steuern der Frequenzdetektionsperiode sendet.

18. Frequenzdetektor mach Anspruch 1, wobei das HF-Run-Length-Signal eine HF-Run-Length umfasst, die in einem Wiedergabesystem für optische Platten des Blue-ray-Typs verwendet wird.

19. Frequenzdetektor nach Anspruch 1, wobei das HF-Run-Length-Signal eine HF-Run-Length umfasst, die in einem Wiedergabesystem für optische Platten des HD-DVD-Typs (High Definition Digitale Versatile Disc type) verwendet wird.

20. Frequenzdetektor nach Anspruch 1, umfassend:

eine Vielzahl von Zählereinheiten (330_1-330_n), die einer Anzahl von Run-Length-Bereichen entsprechen, zum Erzeugen eines Zählergebnisses, wobei jede Einheit zum Zählen der detektierten Run-Length-Signale in den entsprechenden Run-Length-Bereich aufgeteilt ist, um ein Bereichszählergebnis bereitzustellen, das in das Zählergebnis inkludiert wird.

21. Frequenzdetektor nach Anspruch 20, wobei die Run-Length-Bereiche einen ersten Run-Length-Bereich, der Run-Length-Signalen mit einer ersten Länge entspricht, und einen zweiten Run-Length-Bereich umfassen, der Run-Length-Signale mit einer zweiten Länge, die von der ersten Länge verschieden ist, entspricht, die Run-Length-Signal-Detektionseinheit (320) die Run-Length-Signale mit der ersten Länge in den ersten Run-Length-Bereich und die Run-Length-Signale mit der zweiten Länge in den zweiten Run-Length-Bereich den detektierten Längen entsprechend aufteilt und die Vielzahl von Zählereinheiten eine erste Zählereinheit (330_1), die die detektierten Run-Length-Signale, aufgeteilt in den ersten Run-Length-Bereich, zählt, um ein Zählergebnis des ersten Bereichs, das in das Zählergebnis inkludiert wird, bereitzustellen, und eine zweite Zählereinheit (330_n) umfassen, die die detektierten Run-Length-Signale, aufgeteilt in den zweiten Run-Length-Bereich, zählt, um ein Zählergebnis für den zweiten Bereich, das in das Zählergebnis inkludiert wird, bereitzustellen.

22. Frequenzdetektor nach Anspruch 20, wobei die Run-Length-Bereiche erste bis n Run-Length-Bereiche enthalten, die Run-Length-Signalen mit ersten bis n Längen entsprechen, wobei n eine maximale Run-Length ist, die in das HF-Signal inkludiert werden kann,

die Run-Length-Signal-Detektionseinheit (320) die ersten bis n Längen der Run-Length-Signale detektiert und die Run-Length-Signale entsprechend den detektierten Längen in entsprechende erste und n Run-Length-Bereiche aufteilt und

die Vielzahl von Zählereinheiten (330_1-330_n) erste bis n-te Zählereinheiten umfasst, um Zählergebnisse zu erzeugen, wobei die erste Zählereinheit die detektierten Run-Length-Signale, die in den ersten Run-Length-Bereich aufgeteilt sind, zählt, um ein Zählergebnis des ersten Bereichs, das in das Zählergebnis inkludiert wird, bereitzustellen, und die zweiten bis n-ten Zählereinheiten (330_2-330_n) die entsprechenden detektierten Run-Length-Signale, die in die zweiten bis einschließlich n-ten Run-Length-Bereiche aufgeteilt sind, zählt, um entsprechende Zählergebnisse des zweiten bis n-ten Bereichs, die in das Zählergebnis inkludiert werden, bereitzustellen.

23. Frequenzdetektor nach Anspruch 22, wobei n 11T Run-Lengths entspricht.

24. Frequenzdetektor nach Anspruch 22, wobei n 8T Run-Lengths entspricht.

25. Frequenzdetektor nach Anspruch 20, wobei die Frequenzfehler-Erzeugungseinheit (340) die Bereichszählergebnisse für die Run-Length-Bereiche mit einem vorab ausgewählten Profil von erwarteten Bereichszählergebnissen vergleicht, um ein Vergleichsergebnis festzustellen, und den Frequenzfehler dem festgestellten Vergleichsergebnis entsprechend erzeugt.

26. Frequenzdetektor nach Anspruch 25, wobei die Frequenzfehler-Erzeugungseinheit enthält:

einen Speicher, der für jedes potenzielle Vergleichergebnis einen Frequenzfehler speichert, und

eine Frequenzfehlereinheit, die den Vergleich feststellt, aus dem Speicher einen der Frequenzfehler, der dem Vergleichsergebnis entspricht, auswählt und den ausgewählten Frequenzfehler ausgibt.

27. Optische Aufzeichnungs- und/oder Wiedergabevorrichtung, die den Frequenzdetektor nach Anspruch 22 enthält, wobei n der maximalen Run-Length eines durch die Vorrichtung wiedergegebenen optischen Aufzeichnungsmediums entspricht.

28. Optische Aufzeichnungs- und/oder Wiedergabevorrichtung, die den Frequenzdetektor nach Anspruch 20 enthält, wobei die Anzahl von Run-Length-Bereichen und die Anzahl von Zählereinheiten einer maximalen Run-Length eines durch die Vorrichtung wiedergegebenen optischen Aufzeichnungsmediums entsprechen.

29. Optische Aufzeichnungs- und/oder Wiedergabevorrichtung, die den Frequenzdetektor nach einem der Ansprüche 1 bis 26 enthält.

30. Verfahren zum Detektieren eines Frequenzfehlers, geeignet zur Verwendung in einem Wiedergabesystem für optische Platten, das Verfahren umfasst:

Aufteilen eines Run-Length-Bereichs, in dem ein Run-Length-Signal zu detektieren ist, in wenigstens zwei Run-Length-Bereiche auf Basis einer vorausberechneten Verteilungsdichte von Run-Length-Signalen (1501),

Detektieren von Run-Length-Signalen aus einem abgetasteten HF-Signal, entsprechend jedem der aufgeteilten Run-Length-Bereiche (1502),

Zählen der in jedem aufgeteilten Run-Length-Bereich detektierten Run-Length-Signale und Auswählen und Ausgeben eines Frequenzfehlers in einer Frequenzdetektionsperiode aus einer Vielzahl von vorgegebenen Frequenzfehlern auf Basis eines Vergleichens einer Anzahl von in jedem aufgeteilten Run-Length-Bereich gezählten Run-Length-Signalen und eines vorgegebenen Schwellenwertes von jedem Run-Length-Bereich (1504, 1505).

**Revendications**

1. Détecteur de fréquence dans un système de lecture de disque optique, comportant :

une unité de détection de signal de longueur variable (320) qui détecte des signaux de longueur variable dans un signal radiofréquence échantillonné dans une période de détection de fréquence, sur la base d'une densité de distribution prédite de signaux de longueur variable,

une unité de comptage (330) incluant au moins une compteur (330_1 à 330_n) qui compte les signaux de longueur variable détectés dans la période de détection de fréquence,

un compteur de fronts (310) qui compte des fronts de passage du signal radiofréquence échantillonné pour commander la période de détection de fréquence, et

une unité de génération d'erreur de fréquence (340) qui génère une erreur de fréquence dans la période de détection de fréquence, en utilisant le résultat de comptage délivré en sortie par le au moins un compteur (330_1 à 330_n) et une valeur de référence prédéterminée.

**2.** Détecteur de fréquence selon la revendication 1, dans lequel l'unité de détection de signal de longueur variable (320) détecte les signaux de longueur variable dans le signal RF échantillonné conformément à des régions de longueur variable correspondantes dans lesquelles les signaux de longueur variable sont divisés sur la base de la densité de distribution prédite.

**3.** Détecteur de fréquence selon la revendication 1 ou 2, dans lequel chacune des régions de longueur variable correspond à au moins une longueur variable xT, où x est un nombre entier allant de 2 à n, et n est déterminé conformément à des longueurs variables maximales de divers types de disques compatibles avec le système de lecture de disque optique.

**4.** Détecteur de fréquence selon la revendication 3, dans lequel les régions de longueur variable comportent de plus au moins une autre longueur variable qui couvre des longueurs variables à l'exception des longueurs variables 2T à nT.

**5.** Détecteur de fréquence selon l'une quelconque des revendications 1 à 4, dans lequel l'unité de comptage (330) comporte un nombre total des compteurs égal à un nombre de régions de longueur variable utilisées par l'unité de détection de signal de longueur variable.

**6.** Détecteur de fréquence selon la revendication 5, dans lequel :

chacun des compteurs (330_1 à 330_n) compte une valeur qui correspond à un nombre de signaux de longueur variable générés dans la région de longueur variable correspondante, la valeur de référence prédéterminée est un seuil déterminé sur la base de la densité de distribution prédite de signaux de longueur variable à générer dans les régions de longueur variable correspondantes dans la période de détection de fréquence, et l'unité de génération d'erreur de fréquence (340) génère l'erreur de fréquence, sur la base d'une comparaison, pour chacune des régions de longueur variable, de la valeur de comptage attribuée à la région de longueur variable et de la valeur de référence prédéterminée correspondante.

**7.** Détecteur de fréquence selon l'une quelconque des revendications précédentes, dans lequel l'unité de détection de signal de longueur variable (320) détecte un signal de longueur variable de fréquence élevée dans le signal radiofréquence échantillonné, sur la base de la densité de distribution prédite du signal de longueur variable.

**8.** Détecteur de fréquence selon la revendication 7, dans lequel :

l'unité de comptage comporte un compteur, la valeur de référence prédéterminée correspond à la densité de distribution prédite du signal de longueur variable de fréquence élevée, et l'unité de génération d'erreur de fréquence génère l'erreur de fréquence en utilisant un signal correspondant à une valeur obtenue en soustrayant la valeur de comptage de la valeur de référence prédéterminée.

**9.** Détecteur de fréquence selon l'une quelconque des revendications précédentes, dans lequel le compteur de fronts compte les fronts de passage en utilisant une valeur prédéterminée qui est déterminée sur la base d'une plage qui permet l'évaluation de la densité de distribution des signaux de longueur variable du signal RF échantillonné.

**10.** Détecteur de fréquence selon la revendication 1, 2, 3 ou 4, dans lequel l'unité de détection de signal de longueur variable (320) comporte :

une unité de détection de point de passage par zéro (610) conçue pour détecter un point de passage par zéro du signal radiofréquence échantillonné, une unité de détection de signal de longueur variable (620) conçue pour détecter le signal de longueur variable dans le signal radiofréquence échantillonné, et une unité de génération de signal de validation (130) qui génère un signal de validation pour la région de longueur variable correspondant au signal de longueur variable détecté en utilisant un signal délivré en sortie par l'unité de détection de point de passage par zéro (610), un signal délivré en sortie par l'unité de détection de signal de longueur variable (620), et une valeur de frontière de région de longueur variable prédéterminée, et délivre en sortie le signal de validation à l'unité de comptage (330) correspondant à la région de longueur variable du signal de longueur variable détecté.

**11.** Détecteur de fréquence selon la revendication 10, dans lequel l'unité de détection de point de passage par zéro (610) comporte :

un sélecteur de signe (611) qui transforme le signal radiofréquence échantillonné en un signal de forme rectangulaire, un premier retard (612) qui retarde une sortie du sélecteur de signe (610), une porte XOR (613) réalisant une opération XOR sur la sortie du sélecteur de signe (611) et une sortie du premier retard (612),
un deuxième retard qui retarde une sortie de la porte XOR (613), et
une porte ET (615) effectuant une opération ET sur une horloge d'échantillonnage d'un système de lecture de disque optique et une sortie du deuxième retard (614).

12. Détecteur de fréquence selon la revendication 11, dans lequel l'unité de détection de signal de longueur variable (620) comporte :

   une unité d'opération de valeur absolue (621) qui calcule une valeur absolue du signal radiofréquence échantillonné,
   un troisième retard (622) qui retarde une sortie de l'unité d'opération de valeur absolue (621),
   une unité d'opération de distance (623) qui calcule une distance entre les signaux radiofréquence échantillonnés, en utilisant la sortie de l'unité d'opération de valeur absolue (621) et une sortie du troisième retard (622), et
   un circuit logique (629) qui accumule 1T entre des points de passage par zéro et détecte le signal de longueur variable, en utilisant la sortie de la porte XOR (613) et une sortie de l'unité d'opération de distance (623), où 1T désigne une période de l'horloge d'échantillonnage du système de lecture de disque optique.

13. Détecteur de fréquence selon la revendication 12, dans lequel le circuit logique (629) comporte :

   un multiplexeur (624) qui transmet la sortie de l'unité d'opération de distance (623) au point de passage par zéro en utilisant la sortie de la porte XOR (613),
   un quatrième retard (626) qui retarde une sortie du multiplexeur (624),
   un premier additionneur (625) qui délivre en sortie une somme de 1T et d'une sortie du quatrième retard (626) au multiplexeur de sorte qu'une somme est transmise via le multiplexeur en un point autre que le point de passage par zéro,
   un soustracteur (627) qui soustrait la sortie de l'unité d'opération de distance (623) de 1T, et
   un second additionneur (628) qui additionne une sortie du soustracteur (627) et la sortie du quatrième retard (626) et délivre en sortie le résultat d'addition en tant que signal de longueur variable détecté.

14. Détecteur de fréquence selon l'une quelconque des revendications 10 à 13, dans lequel l'unité de génération de signal de validation (630) comporte :

   une matrice de comparaison (631) qui compare le signal délivré en sortie par l'unité de détection de signal de longueur variable (620) et la valeur de frontière de région de longueur variable prédéterminée en utilisant une pluralité de comparateurs, et contrôle la région de longueur variable correspondant au signal de longueur variable détecté, et
   une matrice de portes ET (632) qui effectue une opération ET sur un signal délivré en sortie par un comparateur correspondant de la matrice de comparaison, le signal délivré en sortie par l'unité de détection de point de passage par zéro, et un signal délivré en sortie par un comparateur adjacent au comparateur correspondant, en utilisant une pluralité de portes ET, recontrôle la région de longueur variable correspondant au signal de longueur variable détecté, et génère le signal de validation conformément aux résultats contrôlés.

15. Détecteur de fréquence selon la revendication 1, dans lequel l'unité de génération d'erreur de fréquence (340) comporte :

   une matrice de comparaison (1110) incluant une pluralité de comparateurs qui correspondent respectivement à la pluralité des compteurs et qui compare une valeur de comptage de chacun des compteurs au seuil prédéterminé de la région de longueur variable correspondante,
   une table logique (1120) qui sélectionne et délivre en sortie l'une d'une pluralité d'erreurs de fréquence prédéterminées mémorisées dans la table en réponse à des signaux délivrés en sortie par les comparateurs de la matrice de comparaison, et
   un multiplexeur (1130) qui transmet un signal délivré en sortie par la table logique (1120) en tant qu'erreur de fréquence lorsque le compteur de fronts fournit un signal de validation de sortie pour commander la période de détection de fréquence.

16. Détecteur de fréquence selon la revendication 19, dans lequel l'unité de détection de signal de longueur variable (1201) comporte :

   un unité de détection de point de passage par zéro (1310) qui détecte un point de passage par zéro du signal radiofréquence échantillonné,
   une unité de détection de signal de longueur variable (1320) qui détecte des signaux de longueur variable dans le signal radiofréquence échantillonné, et
   une unité de génération de signal de validation (1330) qui génère un signal de validation selon que le signal de longueur variable de fréquence élevée est détecté par comparaison à d'autres signaux de longueur variable, en utilisant une comparaison de la plus petite limite supérieure et de la plus grande limite inférieure déterminées sur la base du signal de longueur variable de fréquence élevée au signal de longueur variable détecté, et un signal délivré en sortie par l'unité de détection de point de passage par zéro (1310).

17. Détecteur de fréquence selon la revendication 16, dans lequel l'unité de génération d'erreur de fréquence (1204) comporte :

un soustracteur (1401) qui soustrait la valeur de comptage, qui est délivrée en sortie par le compteur (1203), de la valeur prédite prédéterminée, un amplificateur (1402) qui amplifie une sortie du soustracteur (1401) à une valeur prédéterminée, un multiplexeur (1403) qui transmet une sortie de l'amplificateur (1402) en tant qu'erreur de fréquence lorsque le compteur de fronts (1202) transmet un signal de validation de sortie pour commander la période de détection de fréquence.

18. Détecteur de fréquence selon la revendication 1, dans lequel le signal de longueur variable de fréquence élevée constitue une longueur variable de fréquence élevée utilisée dans un système de lecture de disque optique de type Blue-ray.

19. Détecteur de fréquence selon la revendication 1, dans lequel le signal de longueur variable de fréquence élevée constitue une longueur variable de fréquence élevée dans un système de lecture de disque optique de type disque numérique universel haute définition (HD-DVD).

20. Détecteur de fréquence selon la revendication 1, comportant :

une pluralité d'unités de comptage (330_1 à 330_n) correspondant à un nombre de régions de longueur variable pour générer un résultat de comptage, chaque unité de comptage servant à compter les signaux de longueur variable détectés séparés dans la région de longueur variable correspondante pour fournir un résultat de comptage de région inclus dans le résultat de comptage.

21. Détecteur de fréquence selon la revendication 20, dans lequel :

les régions de longueur variable comportent une première région de longueur variable correspondant à des signaux de longueur variable ayant une première longueur, et une seconde région de longueur variable correspondant à des signaux de longueur variable ayant une seconde longueur autre que la première longueur, l'unité de détection de signal de longueur variable (320) sépare les signaux de longueur variable ayant la première longueur dans la première région de longueur variable et les signaux de longueur variable ayant la seconde longueur dans la seconde région de longueur variable conformément aux longueurs détectées, et la pluralité d'unités de comptage comporte une première unité de comptage (330_1) qui compte les signaux de longueur variable détectés séparés dans la première région de longueur variable pour fournir un premier résultat de comptage de région inclus dans le résultat de comptage, et une seconde unité de comptage (330_n) qui compte les signaux de longueur variable détectés séparés dans la seconde région de longueur variable pour fournir un second résultat de comptage de région inclus dans le résultat de comptage.

22. Détecteur de fréquence selon la revendication 20, dans lequel :

les régions de longueur variable incluent des première à n régions de longueur variable correspondant à des signaux de longueur variable ayant des première à n longueurs, où n est une longueur variable maximale pouvant être incluse dans le signal radiofréquence, l'unité de détection de signal de longueur variable (320) détecte les première à n longueurs des signaux de longueur variable et sépare les signaux de longueur variable dans les première et n régions de longueur variable correspondantes conformément aux longueurs détectées, et la pluralité d'unités de comptage (330_1 à 330_n) comporte des première à n-ième unités de comptage pour générer le résultat de comptage, où la première unité de comptage compte les signaux de longueur variable détectés séparés dans la première région de longueur variable pour fournir un premier résultat de comptage de région inclus dans le résultat de comptage, et les deuxième à n-ième unités de comptage (330_2 à 330_n) comptent les signaux de longueur variable détectés correspondants séparés dans les deuxième à n-ième régions de longueur variable pour fournir des deuxième à n-ième résultats de comptage de région correspondants inclus dans le résultat de comptage.

23. Détecteur de fréquence selon la revendication 22, dans lequel n correspond à 11T longueurs variables.

24. Détecteur de fréquence selon la revendication 22, dans lequel n correspond à 8T longueurs variables.

**25.** Détecteur de fréquence selon la revendication 20, dans lequel l'unité de génération d'erreur de fréquence (340) compare les résultats de comptage de région pour les régions de longueur variable à un profil présélectionné de résultats de comptage de région prédits pour détecter un résultat de comparaison, et génère l'erreur de fréquence conformément au résultat de comparaison détecté.

**26.** Détecteur de fréquence selon la revendication 25, dans lequel l'unité de génération d'erreur de fréquence inclut :

> une mémoire qui mémorise, pour chaque résultat de comparaison potentiel, une erreur de fréquence, et
> une unité d'erreur de fréquence qui détecte la comparaison, sélectionne dans la mémoire l'une des erreurs de fréquence correspondant au résultat de comparaison, et délivre en sortie l'erreur de fréquence sélectionnée.

**27.** Dispositif d'enregistrement et/ou lecture optique incluant le détecteur de fréquence selon la revendication 22, dans lequel n correspond à la longueur variable maximale d'un support d'enregistrement optique lu par le dispositif.

**28.** Dispositif d'enregistrement et/ou lecture optique incluant le détecteur de fréquence selon la revendication 20, dans lequel le nombre de régions de longueur variable et le nombre d'unités de comptage correspondent à une longueur variable maximale d'un support d'enregistrement optique lu par le dispositif.

**29.** Dispositif d'enregistrement et/ou lecture optique incluant le détecteur de fréquence selon l'une quelconque des revendications 1 à 26.

**30.** Procédé de détection d'erreur de fréquence approprié pour être utilisé dans un système de lecture de disque optique, le procédé comportant les étapes consistant à :

> diviser une région de longueur variable, dans laquelle un signal de longueur variable doit être détecté, en au moins deux régions de longueur variable sur la base d'une densité de distribution prédite de signaux de longueur variable (1501),
> détecter des signaux de longueur variable dans un signal radiofréquence échantillonné conformément à chacune des régions de longueur variable divisées (1502),
> compter les signaux de longueur variable détectés dans chaque région de longueur variable divisée, et
sélectionner et délivrer en sortie une erreur de fréquence dans une période de détection de fréquence parmi une pluralité d'erreurs de fréquence prédéterminées, sur la base d'une comparaison de nombreux signaux de longueur variable comptés dans chaque région de longueur variable divisée et d'un seuil prédéterminé de chaque région de longueur variable (1504, 1505).

# FIG. 1 (PRIOR ART)

EP 1 734 530 B1

# FIG. 2 (PRIOR ART)

SYNCHRONIZATION PATTERN

## FIG. 3

2T_up  3T_up  ... nT_up

3T_thr  nT_thr
2T_thr  ...  other_thr

SAMPLING CLOCK

SAMPLED RF SIGNAL

RUN-LENGTH SIGNAL DETECTING UNIT (320)

330

2Tsignal

3Tsignal

nTsignal

OTHER SIGNAL

330_1
2T COUNTER
clr

330_2
3T COUNTER
clr

330_n-1
nT COUNTER
clr

330_n
OTHER COUNTER
clr

FREQUENCY ERROR GENERATING UNIT (340) ⟶ FREQUENCY ERROR

out_en

310
EDGE COUNTER

PREDETERMINED VALUE ⟶

EP 1 734 530 B1

## FIG. 4

## FIG. 5

FIG. 6

Sampled RF Signal

610 — 611 SIGN SELECTOR, 612 D, 613 XOR, 614 D, 615 AND, SAMPLING CLOCK

620 — 621 ABSOLUTE VALUE OPERATION UNIT, 622 D, 623 DISTANCE OPERATION UNIT (A, B), 624 MUX (1, 0), 625, 626 D, 627, 628, 629, 1T

630 — 631: 631_1 (2T-up, a b, a < b), 631_2 (3T-up), 631_3 (4T-up), 631_n-1 ((n-1)T-up), 631_n (nT-up)

632 — 632_1, 632_2, 632_3, 632_n-1, 632_n

2Tsignal, 3Tsignal, 4Tsignal, (n-1)Tsignal, nTsignal

THE OTHER SIGNAL

24

# FIG. 7

# FIG. 8

## FIG. 9

## FIG. 10

FIG. 11

# FIG. 12

FIG. 13

# FIG. 14

1204

out_en

xT_count

1401                1402

xT_ideal

1403

AMPLIFIER

1

"0"        0

FREQUENCY ERROR

# FIG. 15

START

DIVIDE RUN-LENGTH REGION, BASED ON PREDICTED DISTRIBUTION DENSITY OF RUN-LENGTH SIGNAL — 1501

DETECT RUN-LENGTH SIGNAL FROM SAMPLED RF SIGNAL FOR EACH RUN-LENGTH REGION — 1502

COUNT RUN-LENGTH SIGNALS DETECTED IN EACH RUN-LENGTH REGION — 1503

COMPARE COUNTING RESULT FOR EACH RUN-LENGTH REGION WITH PREDETERMINED REFERENCE VALUE OF EACH RUN-LENGTH REGION — 1504

GENERATE FREQUENCY ERROR IN FREQUENCY DETECTION PERIOD BASED ON COMPARISON RESULT — 1505

END

# FIG. 16

START

DETECT OF HIGH FREQUENCY RUN-LENGTH SIGNAL FROM SAMPLED RF SIGNAL BASED ON PREDICTED DISTRIBUTION DENSITY OF RUN-LENGTH SIGNAL — 1601

COUNT RUN-LENGTH SIGNALS DETECTED IN FREQUENCY DETECTION PERIOD — 1602

GENERATE FREQUENCY ERROR USING COUNTING RESULT AND PREDICTED VALUE — 1603

END

# FIG. 17

USER INPUT

RECORDING/
READING UNIT — 1701

CONTROLLER — 1702

MEMORY — 1703

1700

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004038719 A